# EUROPÄISCHE PATENTANMELDUNG

(11) **EP 1 724 082 A1**
(43) Veröffentlichungstag der Anmeldung: **22.11.2006**
(21) Anmeldenummer: 06009603.9
(22) Anmeldetag: 10.05.2006
(51) Int. Cl.: B28D 5/00

(54) **Vorrichtung zum Brechen eines dünnen plattenförmigen Gegenstands**

(30) Priorität: 20.05.2005 DE 102005023238
(71) Anmelder: Sieghard Schiller GmbH & Co. KG, 72820 Sonnenbühl (DE)
(72) Erfinder: Schanz, Willi, 72393 Burladingen (DE); Spitzenberg, Udo, 72116 Mössingen (DE)
(74) Vertreter: Kohler Schmid Möbus

(57) **Zusammenfassung**

Eine Vorrichtung (10) zum Brechen eines dünnen, plattenförmigen Gegenstands (11), insbesondere eines Substrats oder eines Wafers, entlang einer geritzten Linie (12), mit einer zusammengesetzen Auflage, die eine Grundplatte (14) und eine auf deren Oberseite angeordnete nachgiebige, federnd elastisch verformbare Auflagematte (13) umfasst, sowie mit einem in Richtung auf die Auflagematte verfahrbaren Brechstempel (15), wobei der plattenförmige Gegenstand zum Brechen so auf der der Grundplatte abgewandten Oberseite der Auflagematte aufgelegt ist, dass die Verfahrrichtung des Brechstempels auf die geritzte Line zielt, ist dadurch gekennzeichnet, dass die Auflagematte auf ihrer der Grundplatte zugewandten Unterseite in Verfahrrichtung des Brechstempels und damit im Betrieb unterhalb der geritzten Linie des plattenförmigen Gegenstandes eine nicht bis zur Oberseite der Auflagematte sich erstreckende Freisparung (16) in ihrer der Grundplatte zugewandten Unterseite aufweist. Damit wird mit einfachen Mitteln ein Brechen von dünnen, plattenförmigen Gegenständen verschleißarm und schonend ermöglicht, wobei insbesondere ein Springen des Gegenstands beim Brechen verhindert wird.

## Beschreibung

Die Erfindung betrifft eine Vorrichtung zum Brechen eines dünnen, plattenförmigen Gegenstands, insbesondere eines Substrats oder eines Wafers, entlang einer geritzten Linie, mit einer zusammengesetzten Auflage, die eine Grundplatte und eine auf deren Oberseite angeordnete nachgiebige, federnd elastisch verformbare Auflagematte umfasst, sowie mit einem in Richtung auf die Auflagematte verfahrbaren Brechstempel, wobei der plattenförmige Gegenstand zum Brechen so auf der der Grundplatte abgewandten Oberseite der Auflagematte aufgelegt ist, dass die Verfahrrichtung des Brechstempels auf die geritzte Line zielt.

Eine solche Vorrichtung ist beispielsweise aus der DE 100 07 642 C2 bekannt.

In der Elektronikindustrie werden aus relativ großflächigen Wafern oder Substraten eine Vielzahl von elektronischen Schaltungen hergestellt, wobei die Wafer oder Substrate zur Herstellung der Schaltungen bedruckt und mit entsprechenden Komponenten bestückt werden. Die Vielzahl der auf dem Substrat oder Wafer befindlichen Flächen für die Schaltungen, die auch als Einzelnutzen bezeichnet werden, müssen entweder im Rohzustand des Substrats oder Wafers oder im bereits bedruckten und/oder bestückten Zustand vereinzelt werden. Dazu werden die Einzelnutzen durch Ritzlinien voneinander abgetrennt und anschließend das Substrat oder der Wafer entlang der Ritzlinien gebrochen.

Nach einem gebräuchlichen Verfahren zum Brechen von Substraten oder Wafern wird das Substrat oder der Wafer derart auf einen Brechtisch aufgelegt, dass die Ritzlinie entlang der Brechtischkante verläuft. Das Substrat wird dann mittels eines Niederhalters auf dem Brechtisch festgeklemmt und der abzutrennende Substratabschnitt mittels eines Brechschwerts durch Einleitung einer Biegekraft von oben auf den abzutrennenden Substratteil abgebrochen. Der Bruch verläuft entlang der Brechkante. Nachteilig am bekannten Verfahren ist, dass durch den Niederhalter und das Brechschwert eine Berührung des Substrats von oben erfolgt. Die Oberseite ist oft bereits bedruckt oder bestückt, sodass hier Beschädigungen auftreten können.

Durch die Verwendung eines Brechtischs mit harter Oberfläche und den Einsatz eines ebenfalls harten Brechschwerts treten insbesondere beim Brechen von Keramiksubstraten Verschleiß am Brechschwert und an der Kante des Brechtisches auf, bzw. es entstehen Brechsplitter und Brechmehl beim Substrat. Ein weiterer Nachteil des bekannten Verfahrens besteht darin, dass der abgebrochene Substratteil nach dem Bruch keine Unterstützung mehr erfährt, sodass es zu einem Wegspringen des abgetrennten Abschnitts kommen kann. Weiterhin ist es schwierig, die Ritzlinie genau über der Brechkante zu positionieren, wenn sich die Ritzlinie auf der Substratoberseite, d. h. gegenüberliegend zum Brechtisch, befindet.

Alternativ dazu sind Brechvorrichtungen, bei denen die Auflageplatte zweiteilig aufgebaut ist, wobei die beiden Teile über ein horizontal verlaufendes Scharnier zusammenhängen. Eine solche Brechvorrichtung ist beispielsweise aus der DE 103 14 179 A1 bekannt. Zum Brechen einer auf dieser Auflageplatte im Bereich des Scharniers aufgelegten Keramikplatte wird dann die eine Teilplatte der Auflageplatte gegenüber der Horizontalen verschwenkt. Dazu muss allerdings die Ritzlinie der Keramikplatte, also die Sollbruchstelle, genau parallel zum Scharnier positioniert werden. Außerdem ist natürlich eine zweigeteilte, bewegliche Auflageplatte mechanisch erheblich aufwändiger und teurer in der Herstellung sowie im Betrieb schwieriger handhabbar als eine starre einteilige Platte.

Der vorliegenden Erfindung liegt demgegenüber die Aufgabe zugrunde, eine Vorrichtung der eingangs beschriebenen Art mit möglichst einfachen Mittel so zu modifizieren, dass ein Brechen von dünnen, plattenförmigen Gegenständen verschleißarm und schonend möglich ist, wobei insbesondere ein Springen des Gegenstands beim Brechen verhindert werden soll.

Erfindungsgemäß wird diese Aufgabe auf ebenso überraschend einfache wie wirkungsvolle Art und Weise dadurch gelöst, dass die Auflagematte auf ihrer der Grundplatte zugewandten Unterseite in Verfahrrichtung des Brechstempels und damit im Betrieb unterhalb der geritzten Linie des plattenförmigen Gegenstandes eine nicht bis zur Oberseite der Auflagematte sich erstreckende Freisparung in ihrer der Grundplatte zugewandten Unterseite aufweist. Dadurch ist während des Brechvorgangs eine ständige mechanische Unterstützung des plattenförmigen Gegenstandes gewährleistet, sodass ein Springen, insbesondere beim Brechen von Keramiksubstrat oder dünnen Siliziumwafern, sicher verhindert wird.

Besonders bevorzugt ist eine Ausführungsform der erfindungsgemäßen Vorrichtung, bei der die Freisparung oval, insbesondere halbkreisförmig ist. Hierdurch lässt sich eine besonders günstige Kraftverteilung der Unterstützungskraft auf das Substrat beim Brechen entsprechend des Konturverlaufs der Freisparung mit besonders großer Unterstützung seitlich der Brechlinie erzielen. Gerade bei einer ovalen oder halbkreisförmigen Freisparung wird die Gefahr des Springens eines Keramiksubstrats beim Brechen weiter minimiert, da die Druckbelastung des Substrats beim Brechvorgang besonders gering ist.

Bei einer alternativen Ausführungsform ist die Freisparung in Richtung auf die Oberseite der Auflagematte keilförmig zulaufend. Hierdurch ergibt sich zwar nicht die optimale Kraftverteilung wie bei der oben beschriebenen Ausführungsform mit ovaler Freisparung, jedoch ist die Herstellung einer keilförmigen Freisparung fertigungstechnisch erheblich einfacher und daher preisgünstiger.

Besonders bevorzugt ist eine weitere Ausführungsform der erfindungsgemäßen Vorrichtung, bei der die Auflagematte eine Gewebeverstärkung aufweist. Damit können besonders hohe Lebensdauern der Auflagematten erzielt werden. Es treten praktisch keine Ausfallzeiten der Maschine auf und die Maschinenstillstandszeiten, die beim turnusmäßigen Wechsel einer Auflagematte erforderlich werden, sind auf ein Minimum reduziert. Außerdem erhöht die Gewebeverstärkung die Biegefestigkeit der Auflagematte.

Eine kostengünstige Weiterbildung dieser Ausführungsform sieht vor, dass die Auflagematte aus Transportgurtmaterial aufgebaut ist. Dieses Material ist im Handel preiswert und in vielen Varianten leicht erhältlich. In der Regel haben derartige Transportgurtmaterialien auch besonders gute Gleiteigenschaften.

Besonders hohe Lebensdauern der Auflagematten und damit minimale Maschinenausfallzeiten werden bei Ausführungsformen erzielt, bei denen die Auflagematten auf ihrer dem Brechstempel zugewandten Oberseite eine verschleißmindernde Oberflächenbeschichtung aufweisen.

Eine weitere besonders vorteilhafte Ausführungsform der Erfindung sieht vor, dass die Auflagematte auf ihrer der Grundplatte zugewandten Unterseite eine Haftbeschichtung aufweist. Dies erleichtert die Montage der Auflagematte und ermöglicht eine besonders einfache Handhabung. Da hierbei nicht wie üblich ein zweikomponentiger Spezialkleber zum Festkleben der Auflagematte auf der Grundplatte erforderlich ist, geht das Aufbringen der Auflagematte besonders rasch vonstatten.

Eine weitere besonders bevorzugte Ausführungsform der Erfindung zeichnet sich dadurch aus, dass der plattenförmige Gegenstand im Betrieb so positioniert ist, dass die Seite mit der geritzten Linie vom Brechstempel weg weist und auf der Auflagematte aufliegt. Auf diese Weise wird eine definierte Krafteinleitung beim Brechen sichergestellt.

Um ein Verrutschen des zu brechenden Gegenstands zu verhindern ist es von Vorteil, wenn die Auflagematte aus Kunststoff oder Gummimaterial aufgebaut ist.

Eine weitere vorteilhafte Ausführungsform der Erfindung zeichnet sich dadurch aus, dass die Grundplatte aus Metall, vorzugsweise aus Aluminium oder Stahl aufgebaut ist. Hierdurch wird einerseits die erforderliche Biegesteifheit der Grundplatte sichergestellt, andererseits lässt sich bei Verwendung einer Metallplatte relativ einfach eine Verbindung der Grundplatte zu anderen Bauteilen einer Gesamtanordnung, beispielsweise einem Maschinentisch, herstellen.

Weiter ist es von Vorteil, wenn der zu brechende Gegenstand durch Ansaugen mittels einer Unterdruckeinrichtung auf der Auflage niedergehalten wird. Dies ist insbesondere beim Brechen von bereits bedruckten und/oder bestückten Substraten oder Wafern von Vorteil.

Weiter können in der Auflagematte Vakuumkammern vorgesehen sein, die mit Ansaugöffnungen in der Auflage für den Gegenstand verbunden sind. Das Niederhalten des Gegenstands durch Ansaugen ist besonders schonend für die Oberflächen des zu brechenden Gegenstands. Eine weitere Maßnahme zur Schonung des Gegenstandes ist das Vorsehen einer weichen Oberfläche für die Auflagematte.

Der zu brechende Gegenstand kann jedes beliebige dünne, plattenförmige Element sein. Besondere Vorteile ergeben sich jedoch, wenn der zu brechende Gegenstand ein bedrucktes oder unbedrucktes, ein bestücktes oder unbestücktes Keramiksubstrat ist, da sich bei diesen Gegenständen die Vorteile der erfindungsgemäßen Vorrichtung besonders stark auswirken.

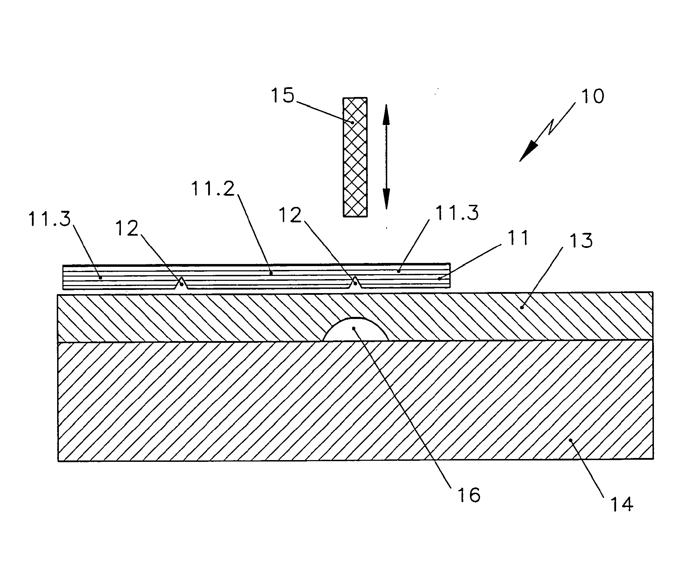

Weitere Merkmale und Vorteile der Erfindung ergeben sich aus der nachfolgenden detaillierten Beschreibung eines Ausführungsbeispiels der Erfindung anhand der Figur der Zeichnung, die erfindungswesentliche Einzelheiten zeigt, sowie aus den Ansprüchen. Die einzelnen Merkmale können je einzeln für sich oder zu mehreren in beliebigen Kombinationen bei Varianten der Erfindung verwirklicht sein.

In der schematischen Zeichnung ist ein Ausführungsbeispiel der Erfindung dargestellt, welches in der nachfolgenden Beschreibung näher erläutert wird.

Die Figur zeigt einen schematischen Querschnitt durch eine erfindungsgemäße Vorrichtung mit einem aufliegenden zu brechenden Gegenstand.

Man erkennt eine Vorrichtung 10 zum Brechen eines dünnen, plattenförmigen Gegenstands 11, hier eines Substrats, das mehrere Einzelnutzen 11.1, 11.2, 11.3 aufweist. Die Einzelnutzen 11.1, 11.2, 11.3 sind jeweils durch Ritzlinien 12 voneinander getrennt. Das Substrat 11 ruht auf einer nachgiebigen, federnd elastischen verformbaren Auflagematte 13, die auf der Oberseite einer Grundplatte 14 angeordnet ist. Das Substrat 11 ist derart auf einer weichen Oberfläche der Auflagematte 13 angeordnet, dass die Ritzlinie 12 zwischen den Einzelnutzen 11.2, 11.3 unterhalb eines Brechstempels 15 liegt, dessen Verfahrrichtung in der Zeichnung durch einen Doppelpfeil angedeutet ist, wobei die Verfahrrichtung genau auf die Ritzlinie 12 zielt.

Die Auflagematte 13 der Vorrichtung 10 weist auf ihrer der Grundplatte 14 zugewandten Unterseite in Verfahrrichtung des Brechstempels 15 und damit unterhalb der geritzten Linie 12 des plattenförmigen Gegenstands 11 eine sich nicht bis zur Oberseite der Auflagematte 13 erstreckende Freisparung 16 auf, die vorzugsweise oval, insbesondere halbkreisförmig, aber auch keilförmig in Richtung auf die Oberseite der Auflagematte 13 zulaufend sein kann.

Bei den in der Zeichnung nicht dargestellten Ausführungsformen kann die Auflagematte 13 eine Gewebeverstärkung besitzen, insbesondere aus Transportgurtmaterial bestehen, eine verschleißmindernde Oberflächenbeschichtung auf ihrer dem Brechstempel 15 zugewandten Oberseite sowie eine Haftbeschichtung auf ihrer der Grundplatte 14 zugewandten Unterseite aufweisen. Die Auflagematte 13 wird in der Regel aus Kunststoff oder Gummimaterial aufgebaut sein, während die Grundplatte 14 aus Metall, vorzugsweise aus Aluminium oder Stahl ist.

Festgehalten wird das Substrat 11 auf der Auflagematte 13 beispielsweise durch eine in der Zeichnung nicht dargestellte Ansaugvorrichtung.

## Patentansprüche

1. Vorrichtung (10) zum Brechen eines dünnen, plattenförmigen Gegenstands (11), insbesondere eines Substrats oder eines Wafers, entlang einer geritzten Linie (12), mit einer zusammengesetzen Auflage, die eine Grundplatte (14) und eine auf deren Oberseite angeordnete nachgiebige, federnd elastisch verformbare Auflagematte (13) umfasst, sowie mit einem in Richtung auf die Auflagematte (13) verfahrbaren Brechstempel (15), wobei der plattenförmige Gegenstand (11) zum Brechen so auf der der Grundplatte (14) abgewandten Oberseite der Auflagematte (13) aufgelegt ist, dass die Verfahrrichtung des Brechstempels (15) auf die geritzte Line zielt,
**dadurch gekennzeichnet,**
**dass** die Auflagematte (13) auf ihrer der Grundplatte (14) zugewandten Unterseite in Verfahrrichtung des Brechstempels (15) und damit im Betrieb unterhalb der geritzten Linie (12) des plattenförmigen Gegenstandes (11) eine sich nicht bis zur Oberseite der Auflagematte (13) erstreckende Freisparung (16) in ihrer der Grundplatte (14) zugewandten Unterseite aufweist.

2. Vorrichtung nach Anspruch 1, **dadurch gekennzeichnet, dass** die Freisparung (16) oval, insbesondere halbkreisförmig ist.

3. Vorrichtung nach Anspruch 1, **dadurch gekennzeichnet, dass** die Freisparung (16) in Richtung auf die Oberseite der Auflagematte (13) keilförmig zulaufend ist.

4. Vorrichtung nach einem der vorhergehenden Ansprüche, **dadurch gekennzeichnet, dass** die Auflagematte (13) eine Gewebeverstärkung aufweist.

5. Vorrichtung nach Anspruch 4, **dadurch gekennzeichnet, dass** die Auflagematte (13) aus Transportgurtmaterial aufgebaut ist.

6. Vorrichtung nach einem der vorhergehenden Ansprüche, **dadurch gekennzeichnet, dass** die Auflagematte (13) auf ihrer dem Brechstempel (15) zugewandten Oberseite eine verschleißmindernde Oberflächenbeschichtung aufweist.

7. Vorrichtung nach einem der vorhergehenden Ansprüche, **dadurch gekennzeichnet, dass** die Auflagematte (13) auf ihrer der Grundplatte (14) zugewandten Unterseite eine Haftbeschichtung aufweist.

8. Vorrichtung nach einem der vorhergehenden Ansprüche, **dadurch gekennzeichnet, dass** der plattenförmige Gegenstand (11) im Betrieb so positioniert ist, dass die Seite mit der geritzten Linie (12) vom Brechstempel (15) wegweist und auf der Auflagematte (13) aufliegt.

9. Vorrichtung nach einem der vorhergehenden Ansprüche, **dadurch gekennzeichnet, dass** die Auflagematte (13) aus Kunststoff oder Gummimaterial aufgebaut ist.

10. Vorrichtung nach einem der vorhergehenden Ansprüche, **dadurch gekennzeichnet, dass** die Grundplatte (14) aus Metall, vorzugsweise aus Aluminium oder Stahl aufgebaut ist.
